(19)

Europäisches Patentamt
European Patent Office
Office européen des brevets

(11) **EP 2 386 619 A1**

(12) **EUROPEAN PATENT APPLICATION**

(43) Date of publication:
**16.11.2011 Bulletin 2011/46**

(51) Int Cl.:
***C09K 11/80*** (2006.01)  ***H01L 33/00*** (2010.01)

(21) Application number: **11170909.3**

(22) Date of filing: **07.11.2006**

(84) Designated Contracting States:
**AT BE BG CH CY CZ DE DK EE ES FI FR GB GR HU IE IS IT LI LT LU LV MC NL PL PT RO SE SI SK TR**

(30) Priority: **22.12.2005 US 315787**

(62) Document number(s) of the earlier application(s) in accordance with Art. 76 EPC:
**06809192.5 / 1 969 086**

(71) Applicant: **Acol Technologies S.A.**
**1245 Satigny (CH)**

(72) Inventor: **The designation of the inventor has not yet been filed**

(74) Representative: **Findlay, Alice Rosemary**
**Reddie & Grose**
**16 Theobalds Road**
**London**
**WC1X 8PL (GB)**

Remarks:
This application was filed on 22-06-2011 as a divisional application to the application mentioned under INID code 62.

(54) **Optically Active Compositions And Combinations Of Same With Indium Gallium Nitride Semiconductors**

(57) New combinations of semiconductor devices in conjunction with optically active materials are set forth herein. In particular, light emitting semiconductors fashioned as diodes from indium gallium nitride constructions are combined with high-performance optically active Langasite $La_3Ga_5SiO_{14}$ crystalline materials. When Langasite is properly doped, it will respond to the light output emissions of the diode by absorbing high energy photons therefrom and reemitting light of longer wavelengths. High-energy short wavelength light mixes with the longer wavelengths light to produce a broad spectrum which may be perceived by human observers as white light. Langasite, a relatively new material, enjoying great utility in frequency control and stabilization schemes has heretofore never been used in combination with optical emission systems.

Fig. 1

**Description**

**BACKGROUND OF THE INVENTIONS**

**Field**

The following invention disclosure is generally concerned with special optically active compositions of matter and these compositions in conjunction with light emitting elements and specifically concerned with compositions of matter comprising Langasite in combination with short-wave light emitting diodes LEDs.

**Prior Art**

A relatively new material known as 'Langasite' or more formally 'lanthanum gallium silicate' has been created and is now finding its way into new inventions due to its remarkable properties. Not only are techniques for forming Langasite the subject of interesting new inventions, but additionally, inventions have been created around the remarkable physical properties displayed by this new material class.

The following important inventions described various techniques for producing Langasite material in specialized, and highly useful forms. These include:

An invention by Kawanaka et al. is entitled "Langasite-type Crystals and a Method for Manufacturing the Same" and is numbered US patent 6,303,048. In this invention a melt containing lanthanum oxide, tantalum oxide, and gallium oxide is prepared by mixing the powders of these oxides so as to have a stoichiometric composition ratio of an intended lanthanum/tantalum/gallium oxide to be manufactured. A seed crystal is placed in a melt and a large crystal is pulled from the melt in an atmosphere containing argon and oxygen according to the Czochralski process.

A single crystal substrate of Langasite may be realized in accordance with the inventions taught by Kumatoriya et al in US patent 6,525,447. The single crystal substrate is formed as a piezoelectric device. More particularly, the steps of polishing at least one of the main surfaces of the raw material substrate and wet etching said polished main surface of the substrate with a solution including $H_3PO_4$, $HNO_3$, and $CH_3COOH$ is presented.

Langasite crystal materials may be manipulated and arranged to operate as specific electronic devices such as oscillators and filters, particularly for frequency (or wavelength) control.

In published United States patent application number 2002/0015452, inventors Chai et al. present an electronic device including Langasite structure compound and method for making such devices. A piezoelectric layer formed of an ordered Langasite structure compound having the formula $A_3BC_3D2E_{14}$; wherein A is strontium, B is niobium, C is gallium, D is silicon, and E is oxygen. These devices may be fashioned as SAW or BAW resonators or filters.

Similarly inventors Takeuchi et al. present a 'surface acoustic wave', or SAW, device comprising a Langasite crystal substrate in US patent numbered 6,285,112. A substrate and electrode structure are formed on a Langasite substrate being made of an X-cut Langasite single crystal, a rotation Y-cut Langasite single crystal, or a double rotation Y-cut Langasite single crystal. The electrode structure is formed to constitute a surface acoustic wave filter having a low insertion loss and an excellent phase property. As such, highly precise frequency control is obtained in such devices.

Further inventions are similarly directed at frequency regulation, control, and filtering.

US patent numbered 6,747,573 by inventors Gerlach et al. present apparatus and method for generating coded high-frequency signals. An apparatus having a converter, converts non-electrical primary energy available from the surroundings into electric energy. For purposes of the herein disclosed inventions, this disclosure relates to very important principles. That is that Langasite material is used in a process relating to the *conversion of energy* from one state to another.

Nortel Networks inventors Steve Beaudin and Hongwei Xu of Ottawa, Canada present oscillator arrangements with improved frequency stability; devices which depend upon the Langasite material. Two oscillators produce respective signals at two different frequencies each dependent upon a parameter such as temperature in accordance with a polynomial with coefficients which are different for the two oscillators. A mixer produces, at a sum or difference frequency of the two signals, an output signal for which a corresponding coefficient of a respective polynomial is substantially zero.

Is easy to see that Langasite materials provide interesting and useful devices in various configurations directed at frequency control. It will be shown later in this presentation, how Langasite materials may be used in remarkably different ways for frequency control at far smaller wavelengths. However, before going on to details regarding that point, is important to address additional elements of the prior art which suggest some very important principles of frequency control, but which do not relate to Langasite type materials. These include:

Various forms of Garnet crystals have been used in conjunction with light shifting strategies in light emitting diode devices. In one of these systems a light emitting device having a nitrite compound semiconductor is combined with a phosphor containing a Garnet fluorescent material. Inventors Shimizu et al. teaches in United States patent numbered 6,069,440 precisely such a device. A light emitting diode semiconductor is covered in some fashion or another with a phosphor material which contains Garnet fluorescent crystals. Light emitted by the diode leaves the junction and exits a semiconductor to interact with the phosphor of Garnet crystals. Light interacts with the Garnet crystals and suffers a wavelength change in the process. In fact, light of short wavelength is changed into light of longer wavelength. Such process has great utility in systems where it is desired that blue light be converted to longer wavelengths; systems of very great demand today. US patent numbered 5,998,925, by the same inventor teaches a very similar invention and presents even greater detail relating thereto.

Inventor Chen of Taiwan also teaches of an LED package structure with ultraviolet light emission and a multilayered resin to generate various colored lights in US patent numbered 5,962,971. The LED package mixes together certain materials which can change the wavelength of light in the resin and enable the LED to generate white light and lights of various other colors as well. These "certain materials" include wavelength shifting fluorescent crystals, which are deposited onto the surface of the ultraviolet light emitting chip.

Particular attention is drawn to the entire field of white light emitting diodes. By far the most common arrangement includes a nitride group III semiconductor, which produces blue or ultraviolet light, in combination with a phosphor of yttrium-aluminum Garnet activated by cerium. One should find no fewer than dozens of patents relating to such combinations in the pertinent arts.

While systems and inventions of the art are designed to achieve particular goals and objectives, some of those being no less than remarkable, these inventions of the arts have limitations which prevent their use in new ways now possible. Inventions of the art are not used and cannot be used to realize the advantages and objectives of the inventions taught herefollowing.

## SUMMARY OF THE INVENTIONS

Comes now, Abramov, V.S.; Shishov, A.V.; Scherbakov, N.V.; and Sochin, N.P. with inventions of light emitting compositions and light emitting compositions in combination with high energy light emitting diodes. It is a primary function of these systems to provide light emitting compositions. It is a major contrast to prior art methods and devices that presented systems do not include expensive yttrium aluminum garnet material.

A high performance optically active material is derived from lanthanum-gallium-silicate, $La_3Ga_5SiO_{14}$ or'Langasite'. When the material is formed, it is doped with select materials to alter crystal sites and optical properties associated therewith. In particular, lanthanides may be added in various concentrations to promote expression of certain desirable properties. Expression of *optical* properties is of particular importance. Langasite materials doped with lanthanides can operate as photophosphors. Particularly, the special class of photophosphor having emission spectra in important regions of the visible spectrum. Further, the excitation spectra are similarly well aligned with a particular desirable function - it may be pumped with UV and blue light. Still further, both the emission and excitation spectra are tunable. As it is a primary objective of these inventions to provide broadband light sources based on semiconductors, a Langasite based photophosphor highly responsive to wavelengths emitted by InGaN type semiconductor diodes which re-emits in the middle of the visible spectrum is highly useful and the subject of this specification. In best mode versions, Langasite crystals are doped with Cerium atoms which naturally enter the crystal lattice to yield an optically active composition. Cerium is not the only lanthanide which makes a good dopant; but rather all of the lanthanides make alternative interesting versions. Indeed *combinations* of lanthanides also make important versions and such combinations are fully anticipated.

Further, variations with respect to the two metal groups, i.e. the group III metals, and the group IV metals are also put forth. In some versions, portions gallium are replaced with indium. In other versions, portions of silicon are replaced with germanium. Combinations of these variations are also fully anticipated.

Compositions formed in accordance with these inventions are characterized by the crystal structure which is described as: $P_{321}(D^2_3)$. Further, the material is prepared in a manner whereby the average crystal size in a powder is between about 8 and 40 times its peak emission wavelength; or a mean diameter of between about 4 and 20 microns. These criteria will be shown to yield preferred emission characteristics.

Because these unique optically active materials cooperate particularly well certain optical wavelengths, that is, they are highly responsive and efficiently pumped by light of wavelengths between .1- .45um, use of these materials in *conjunction* with special optical systems is considered part of these inventions. In particular, these materials in conjunction with indium gallium nitride semiconductors which emits high energy light in the blue or ultraviolet spectral regions together produce a high performance optical system. Namely, these combinations provide a white emitting semiconductor based optical source.

**Objectives of these Inventions**

It is a primary object of these inventions to provide new crystalline compounds.

It is an object of these inventions to provide new optically active crystalline compounds.

It is a further object to provide optical active crystalline compounds suitable for wavelength shifting functionality.

It is an object of these inventions to provide optical active crystalline compounds which may be optically pumped.

It is an object of these inventions to provide an optically active crystalline compound which provides a stable response with respect to color output in view of temperature changes.

A better understanding can be had with reference to detailed description of preferred embodiments and with reference to appended drawings. Embodiments presented are particular ways to realize these inventions and are not inclusive of all ways possible. Therefore, there may exist embodiments that do not deviate from the spirit and scope of this disclosure as set forth by appended claims, but do not appear here as specific examples. It will be appreciated that a great plurality of alternative versions are possible.

## BRIEF DESCRIPTION OF THE DRAWING FIGURES

These and other features, aspects, and advantages of the present invention will become better understood with regard to the following description, appended claims and drawings where:

Figure 1 is an illustration of a light emitting semiconductor device in conjunction with an optically active compound; and
Figure 2 is an alternative configuration of a similar system.

## GLOSSARY OF SPECIAL TERMS

Throughout this disclosure, reference is made to some terms which may or may not be exactly defined in popular dictionaries as they are defined here. To provide a more precise disclosure, the following terms are presented with a view to clarity so that the true breadth and scope may be more readily appreciated. Although every attempt is made to be precise and thorough, it is a necessary condition that not all meanings associated with each term can be completely set forth. Accordingly, each term is intended to also include its common meaning which may be derived from general usage within the pertinent arts or by dictionary meaning. Where the presented definition is in conflict with a dictionary or arts definition, one must use the context of use and liberal discretion to arrive at an intended meaning. One will be well advised to error on the side of attaching broader meanings to terms used in order to fully appreciate the depth of the teaching and to understand all the intended variations.

### Optically Active

For purposes of these inventions, a material is said to be 'optically active' if the material interacts with light. Both absorption mechanisms and emission mechanisms are considered parts of optically active processes.

### Photophosphor

A 'photo phosphor' is a light emitting material, which may be photonically pumped.

### Light Emitting Semiconductor

A light emitting semiconductor is any solid-state device, which produces light in response to current passing therethrough. Common light emitting semiconductors include semiconductor junctions arranged as diodes as well as more complex configurations including lasers.

## PREFERRED EMBODIMENTS OF THESE INVENTIONS

In accordance with each of preferred embodiments of these inventions, there is provided compositions and systems of optically active materials and combinations of those materials with indium gallium nitride semiconductors. It will be appreciated that each of embodiments described may include both a composition and optical system and that the composition and optical system of one preferred embodiment may be different than the composition and optical system of another embodiment.

Crystals of lanthanum-gallium silicate, Langasite, belong to the class of the piezoelectric materials with average value of the electromechanical coupling coefficient (K -16% for optimal cut). This value of electromechanical coupling coefficient promotes sufficiently high temperature stability of characteristics from one crystal to another, as well as lack of phase transition to the melting temperature is of great interest to specialists working in fields where temperature stability is desired. Basic Langasite characteristics are given below compared to quartz and lithium tantalate.

**Table 1**

| Property | Quartz | Langasite | Lithium tantalite |
|---|---|---|---|
| Symmetry Class | 32 | 32 | 3m |
| Melting temperature, C | 1610 | 1470 | 1650 |
| Phase transition | 573.3 | - | 660 |
| Electromechanical coupling coef | 7 | 16 | 44 |
| Optimum cut | AT | Y | X |
| Temperature coef. of frequency, ppm | .6 | 1.6 | 4 |

It is readily apparent from the prior art that Langasite materials make excellent optical and electronic devices for example use as surface acoustic wave frequency filters. However, systems proposed herein introduce Langasite materials with regard to another of its particular optically active properties. That is, the Langasite crystal interaction with photons; both absorption and spontaneous emission. The Langasite crystal displays interesting properties with respect to photonic output and input. In particular, electrons in the crystal lattice are easily excited by photonic inputs of important spectra. Wavelengths between about .10 and .45 microns 'pump' or excite electrons bound in the crystal lattice. In the natural decay processes, the crystal lattice reemits photons of slightly *lower energies* and longer wavelengths. Because of these characteristics, properly prepared Langasite crystals make good wavelength shifting media. Sometimes and herein referred to as phosphor or 'photophosphors', properly prepared Langasite crystals is shown to be an excellent optically active material with particular valuable uses.

Because the Langasite crystal is highly responsive to ultraviolet and blue light, that is to say the crystal may be readily pumped by these wavelengths, Langasite is an ideal candidate for high-performance phosphors to be used in conjunction with LEDs.

There is presently intense industry activity directed to forming LED systems having white light output. It is highly desirable to fashion LED systems which may be used in general lighting applications. One primary approach gaining significant momentum includes the combination of a high energy LED, i.e. one which emits ultraviolet or blue light, in combination with wavelength shifting phosphors. It is a necessary property of such phosphors that they be stimulated by the ultraviolet and blue light emitted by the semiconductor, and further that they have re-emission wavelengths in the green, yellow, or red regions of the visible spectrum. Light reemitted by the phosphor mixes with blue light emitted by the diode to produce a system broadband spectral output perceived by human viewers as "white" light. Accordingly, a primary part of these inventions includes the combination of an ultraviolet or blue emitting semiconductor device with a Langasite based phosphor.

When preparing Langasite based compositions for such optical systems, there is significant latitude for manipulation of the material components in order to achieve some desired effects. Particularly, during crystal formation, it is possible to introduce material (dopant) which will join the lattice in good order. One can further manipulate the crystal to effect average geometric size - for example, crystals may be ground and sifted into a powder of many small crystal elements of particular size. It is additionally possible to manipulate the formulation processes to yield desirable properties - for example, a baking process may be prescribed to give resulting powder a certain preferred characteristic.

Of particular interest, the Langasite crystal may be doped with *lanthanides* which serve as optical activators. Elements including: Cerium, Scandium, Yttrium, Gadolinium, Ytterbium, Lutetium, Samarium, Europium, Terbium, Erbium, Dysprosium, Praseodymium, Holmium and Thulium; or sometimes herefollowing by their two letter identifiers as follows: Ce, Sc, Y, Gd, Yb, Lu, Sm, Eu, Tb, Er, Dy, Pr, Ho and Tm.

A pure Langasite material may be described as $La_3Ga_5SiO_{14}$. During crystal formation, it is possible to replace some lanthanum atoms with other lanthanides - for example with cerium. Typically, the *amount* of dopant, the 'atomic share', is quite small in comparison to the amount of lanthanum. For example, there may be 100 or even 1000 lanthanum atoms for each cerium atom in a particular composition design.

Introduction of dopants provides certain changes in optical input and output response of the material. Select dopants and concentrations of dopants may cause a wavelength shift in the optical response of the crystal. For example, the pump wavelength having a spectral peak may be up-shifted or down-shifted with the introduction of various materials. Further, the output wavelength, may be shifted, either up or down, as a result of introduction of particular material to the Langasite crystal. It is also possible that the output intensity increases or decreases; and further that the pump efficiency increases or decreases as a result of the introduction of various materials. Each particular dopant may yield its own particular effect. In experimentation, has been determined that introduction of the listed materials has at least the corresponding noted effect on output. These results are tabulated in Table 2 herefollowing.

**Table 2**

| rare-earth element | atomic share | Effect on output |
|---|---|---|
| Y | 0.01-0.3 | intensity increase shift of spectral maximum |
| Gd | 0.01-0.3 | intensity increase shift of spectral maximum |
| Sc | 0.001-0.1 | Intensity increase shift of spectral maximum |
| Lu | 0.001-0.1 | intensity increase shift of spectral maximum |
| Yb | 0.001-0.1 | Change of after luminescence duration |
| Pr | 0.001-0.05 | Appearance of additional max. $\lambda$=615-640 nm |
| Sm | 0.001-0.1 | Change of luminescence intensity |
| Eu | 0.001-0.1 | Change of luminescence intensity |
| Tb | 0.001-0.1 | Change of luminescence Intensity |
| Er | 0.001-0.05 | Change of luminescence intensity |
| Dy | 0.001-0.05 | Change of luminescence Intensity |
| Ho | 0.001-0.05 | Change of luminescence intensity |
| Tm | 0.001-0.05 | Change of luminescence intensity |
| Yb | 0.001-0.05 | Change of luminescence intensity |

In accordance with these inventions, a phosphor activated by cerium ion constitutes one preferred example embodiment. This may be represented in the stoichiometric formula: $La_{3-x}Ce_xGa_5SiO_{14}$ having a crystal Langasite structure belonging to a structure group $P_{321}(D^2_3)$ where the value of stoichiometric index is within the interval x = 0.001 - 0.15. Inorganic phosphor having such formula strongly emits light with a wavelength peak at $\lambda_{max}$= .480 - .580 microns.

When such phosphor is pumped with light emitted from an InGaN diode, some of light emitted from the diode interacts with the phosphor and causes the phosphor to emit light with wavelengths as indicated. Those wavelengths blend with light emitted by the semiconductor but which has not interacted with the phosphor and has kept its original wavelengths. This light together forms a broad spectrum which is perceived as 'white'. It is possible with these configurations to achieve a chromatic temperature from T = 3,000K up to T = 12,000K.

It is not necessary to restrict activation to cerium dopant and the Langasite crystal may be nicely activated with several other elements and combinations of elements from the lanthanides. For example, it is quite possible to dope Langasite with praseodymium to arrive with an emission spectra which peaks in the range of: $\lambda$ = .580 to .620 microns; europium, $\lambda$ = .590 to .625 microns; dysprosium, $\lambda$=.570 microns; terbium, $\lambda$=.480 to .545 microns, and erbium, $\lambda$ = .530 microns.

Such latitude in activator choice also permits great design flexibility with respect to pump wavelengths. This is particularly useful in combinations with nitride based semiconductor emitters which can be tuned for particular outputs. Accordingly, with such good flexibility in wavelength choice, one can more precisely match a photophosphor performance to a particular emitter design to achieve prefer color temperature values.

Langasite phosphor can be prepared in accordance with known ceramic technologies. For example, oxides may be prepared for mixing in the following quantity: $La_2O_3$ 1.49M; $Ga_2O_3$ 2.5M; $SiO_2$ 1M; and $CeO_2$ 0.02M, in accordance with a prescribed stoichiometric formula. The specified oxides are added to 0.05 M boric acid which is used in this particular case as a liquid phase mineralizator. The mixing of oxides is carried out in special devices (attritors) using zircon balls as grinding bodies. These grinding bodies at 1:10 by mixture mass operate on the mix for 2 hours. The mixture is put into alundum crucibles of 0.5 L volume, which are placed into electric furnace with the controlled temperature and an atmosphere of $H_2$:N2, = 2:98. The heating of crucibles is carried out by steps at exposure at T = 500ºC-1 hour; 900ºC-1hour; 1100ºC-1 hour and 1300ºC - 2 hours. Then the content of crucibles is cooled simultaneously with the furnace to 100ºC. The received product is washed by hot acidified (pH=5) water, sifted through a sieve of 400 microns, then dried at T = 120ºC for 2 hours.

When Langasite materials are prepared for use as photophosphors, the crystals are prepared as a powder. After formation, material in crystal form may be further ground into fine powder in various grinding and filtering processes. In this way, one can achieve a phosphor having crystals of a particular choice size necessary for highest performance systems with consideration for emission characteristics such as dispersion.

In the process of experimentation, it has been found that phosphor should be made out of polydisperse grains which geometrical size (diameter) exceeds the emission wavelength peak by about between 8 to 40 times. The preferred lower limit of grain size is from about d = 4 microns, as it has been shown is conditioned by the absence of excess light diffusion reducing a full effectiveness. The upper limit of phosphor grain dimension is from about d = 20 microns and is conditioned by the ability to form unsegregating phosphor suspension in polymer used for developing a translucent layer fastened well at the surface of semiconductor.

Since a primary function for Langasite based phosphors is to be used in conjunction with blue and ultraviolet light emitting semiconductors to achieve a broadband or "white" light output, it is important to mention how the phosphor is brought into 'proximity' with respect to the light emitting semiconductor chip. For proper interaction, photons emitted from the semiconductor chip must fall incident upon doped Langasite crystals. In some basic versions a slurry may be formed and the slurry applied to the semiconductor chip as a covering or coating. Light leaving the semiconductor chip necessarily passes through the slurry and interacts with Langasite crystals.

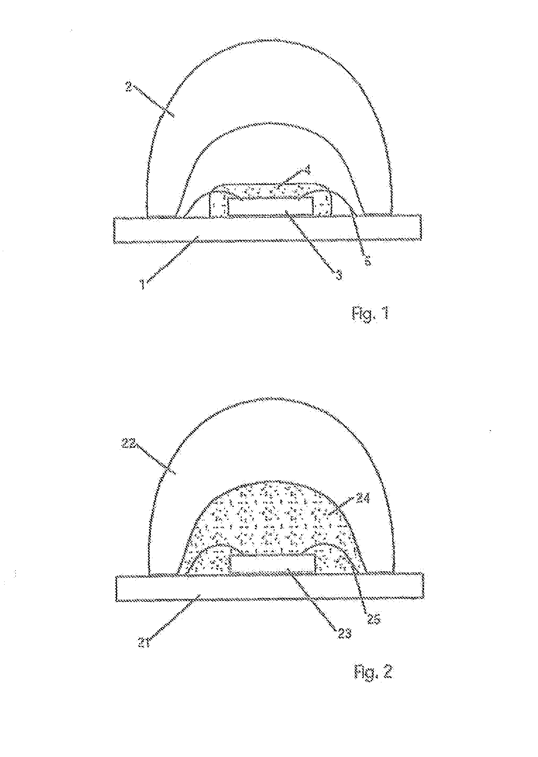

With attention drawn to figure 1, a first preferred version of these inventions is illustrated in the diagram. Particularly, a substrate 1, is joined by a lens element 2 to form an LED semiconductor package. A semiconductor chip, for example an InGaN diode 3, the beam mounted in affixed to the substrate. The semiconductor chip made the thereafter coated by a slurry or otherwise configured layer 4 of material including a phosphor. The chip is electrically connected by wire bonds 5. In some versions, the phosphor is mixed with a relatively transparent binder material and spread directly over the semiconductor chip as is commonly done in the art.

In more advanced versions at colloid is prepared. A polymer material may be used as a binder, into which Langasite crystal may be blended and mixed. The polymer having a thickness and low viscosity tends to hold Langasite crystals in suspension. This makes the polymer with suspended Langasite easy to apply as a gel into cavities, which may also contain appropriate semiconductor chips.

Preferred polymers belong to the group of polyethylsiloxane or polyepoxides having a molecular mass from M = 2000 up to M = 20000 carbon units. Such polymers have sufficiently high viscosity and necessary mobility providing the layer formation out of phosphor grains distributed in polymer. A minimum preferred content of phosphor grains in polymer is from 10% mass shares, whereas the extreme maximum value is about 75%. An optimal average value is from about 45% to about 65% of mass phosphor concentration in polymer. This concentration allows formation of uniform layers strongly fixed on the surface of semiconductor heterojunction with thickness from 20 microns up to 100 existing at all radiating heterojunction surfaces and its luminous flanks.

Figure 2 illustrates a colloidal arrangement where a polymer gel is configured to hold in suspension Langasite based phosphor crystals. A substrate 21 operates in conjunction with lens 22 to form the device package. Semiconductor chip 23 is affixed to the substrate with in a space provided under the lens element. The entire space may be filled with a viscous gel 24. Finally the semiconductor chip is further coupled with an electronic circuit by way of wire bonds 25.

As mentioned in the prior art section above, common and well-known white LED systems typically combine InGaN diodes with YAG based phosphors. Therefore, it is useful to draw comparisons between Langasite phosphors and YAG phosphors for a more complete understanding of the physical differences between these two material types. Table 3 below presents comparisons in symmetry, lattice parameter, structure, molecular mass, density, thermal expansion, heat conduction, melting temperature, refraction indices, among others. The table illustrates that the materials are remarkably different, each having its own physical characteristics, which may be manipulated to benefit various optical systems.

**Table 3**

| Property | $Y_3Al_5O_{12}$:Ce | $La_3Ga_5SiO_{14}$:Ce |
|---|---|---|
| Symmetry | Ia3d | $P_{321}(D^2_3)$ |
| Lattice parameter | a=1.205 | a=0.810 |
| Structure | Cubic | Trigonal |
| Molecular mass | 593.61 | 1017.32 |
| Density r/cM$^3$ | 4.65-5.0 | 5.75 |
| thermal expansion 10$^{-6}$ grade | 8.2 | 3.1-5.1 |
| heat conduction Wt/sm-grade | 0.13 | 0.35 |
| Melting temperature, T$\underline{o}$C | 1950 | 1480 |
| Refraction indices | 1.85-1.95 | 1.92 |

(continued)

| Property | $Y_3Al_5O_{12}$:Ce | $La_3Ga_5SiO_{14}$:Ce |
|---|---|---|
| Concentration of activator, % atomic Ce | 1.0 | До 10 |
| Area of translucency, mcm | 0.24-6 | 0.35-4.0 |
| Position $\lambda_{max}$ of luminescence | 540-580 | 480-600 |

One will note instead of a cubic structure associated with the garnet phosphor, a phosphor of Langasite possesses a trigonal system with two lattice parameters. The lattice bond distance is more similar in size and cooperative with respect to the lanthanide atoms. Because of the nature of the crystal, and the nature of cerium (among other lanthanides), the cooperation is excellent. The phosphor brightness is more easily controlled as cerium is easily 'dissolved' in large quantity into the crystal formulae.

High concentration of cerium ion contributes to the exceptional quantum output of phosphor emission which can reach up to $\eta$ = 90 - 92% in comparison with the best value for YAG phosphor $\eta$ = 82 - 88%. Meanwhile a bit smaller value of index of refraction of Langasite phosphor is given in accordance with the equality $\varphi$ = arctan($n_2/n_1$) provides a larger value of emission output angle from the grains of the phosphor ($n_1$,$n_2$- refraction indices of phosphor grains and binding polymer).

If the refraction coefficient of a garnet phosphor layer at $\lambda$=470 nm equals R =18 - 25%, then for a comparable Langasite phosphor this value is R = 12 - 18%. This refraction coefficient reduction allows reduction of the value of optical diffusion in polymer phosphor layers. In addition, also makes them more uniform in thickness, which in turn will contribute to constancy and stability of the emitted integral white color.

Thermal stress common to garnet phosphor sources are not displayed in Langasite based phosphors and therefore they are better performers in high temperature applications. This is primarily due to a smaller value of the thermal expansion coefficient of Langasite grain prepared in accordance with this description. High heat conduction of these materials also contributes to a smaller value of temperature stresses in polymer layers and organic binder.

The reader will enjoy the benefit of consideration of particular examples of Langasite based phosphor compositions in view of their performance characteristics. Table 4 below presents 15 examples of phosphor compositions. For each composition, the optical output in candela 'cd.' is noted. In addition, the color coordinates are presented along with the description of the color as observed. Finally, the emission half angle, $\theta$, is presented.

**Table 4**

| № | Phosphor composition | Lum. Intn. | Color Coord. | Color | $2\theta$ |
|---|---|---|---|---|---|
| 1 | $La_{2.89}Ce_{0.01}Ga_5SiO_{14}$ | 2.0 | 0.29 0.30 | Bluish- white | 15 |
| 2 | $La_{2.89}Y_{0.1}Ce_{0.01}Ga_5SiO_{14}$ | 2.2 | 0.31 0.33 | Sunny- white | 16 |
| 3 | $La_{2.94}Sc_{0.05}Ce_{0.01}Ga_5SiO_{14}$ | 2.3 | 0.32 0.32 | White | 16 |
| 4 | $La_{2.98}Lu_{0.01}Ce_{0.01}Ga_5SiO_{14}$ | 2.05 | 0.34 0.33 | White | 15 |
| 5 | $La_{2.989}Ce_{0.01}Yb_{0.01}Ga_5SiO_{14}$ | 2.02 | 0.32 0.36 | White/yellow | 16 |
| 6 | $La_{2.69}Gd_{0.3}Ce_{0.01}Ga_5SiO_{14}$ | 2.3 | 0.36 0.38 | White/yellow | 16 |
| 7 | $La_{2.998}Ce_{0.01}Sm_{0.001}Eu_{0.001}Ga_5SiO_{14}$ | 2.00 | 0.32 0.33 | White | 15 |
| 8 | $La_{2.998}Ce_{0.01}Er_{0.001}H_{0.001}Ga_5SiO_{14}$ | 2.00 | 0.32 0.34 | White | 15 |
| 9 | $La_{2.998}Y_{0.09}Ce_{0.2}Tb_{0.001}Ga_5SiO_{14}$ | 2.8 | 0.38 0.40 | Warmly white | 18 |
| 10 | $La_{2.999}Ce_{0.001}Ga_{4.9}Al_{0.1}O_{14}$ | 2.0 | 0.33 0.33 | White | 16 |
| 11 | $La_{2.99}Ce_{0.01}Ga_{4.0}Al_{1.0}O_{14}$ | 2.75 | 0.39 0.42 | Warmly white | 16 |
| 12 | $La_{2.99}Ce_{0.01}Ga_{4.999}Al_{0.001}Sl_{0.99}Ge_{0.01}O_{14}$ | 2.4 | 0.36 0.40 | Warmly white | 16 |
| 13 | $La_{2.99}Ce_{0.01}Ga_{4.7}Al_{0.3}Si_{0.09}Ge_{0.1}O_{14}$ | 2.2 | 0.38 0.38 | Warmly white | 15 |
| 14 | $La_{2.99}Ce_{0.01}Ga_{4.7}Al_{0.3}Sl_{0.7}Ge_{0.3}O_{14}$ | 2.4 | 0.38 0.36 | Warmly white | 15 |
| 15 | $Y_3Al_5O_{12}$:Ce | 1.8-2.2 | 0.31 0.32 | Sunny white | 12 |

The examples above are directed to specific embodiments which illustrate preferred versions of devices and methods of these inventions. In the interests of completeness, a more general description of devices and the elements of which they are comprised as well as methods and the steps of which they are comprised is presented herefollowing.

One will now fully appreciate how high-performance, inexpensive optically active compositions may be used in conjunction with optical systems to perform wavelength shifting functionality. Although the present inventions have been described in considerable detail with clear and concise language and with reference to certain preferred versions thereof including best modes anticipated by the inventors, other versions are possible.

Embodiments of the invention can be described with reference to the following numbered clauses, with preferred features laid out in the dependent clauses:

1) In combination, a light emitting semiconductor and Langasite photophosphor, said light emitting semiconductor proximately positioned with respect to said Langasite photophosphor whereby some of light emitted by the semiconductor interacts with the photophosphor and is shifted in wavelength via phosphor re-emission.

2) The combination of clause 1, said light emitting semiconductor is an InGaN diode structure.

3) The combination of clause 1, said photophosphor is prepared with cerium dopant.

4) Compositions of matter in accordance with:

$$La_{3-x}[Me^1]_5[Me^2]_1O_{14}:[At]_x$$

where:

Me$^1$ is at least one group III metal from the group comprising: Ga or In;
Me$^2$ is at least one group IV metal from the group comprising: Si or Ge;
At$_x$ is the total of at least one lanthanide from the group: Ce, Sc, Y, Gd, Yb, Lu, Sm, Eu, Tb, Er, Dy, Pr, Ho and Tm, where:

$$A_{t_x} = \sum_{i=1}^{N} A_{t_{x_i}} \; ; \text{where } 1 \leq N \leq 14$$

and x is less than 3.

5) Compositions of clause 4, said material is formed as crystals having a crystalline structure characterized by:

$$P_{321}(D^2_3)$$

6) Compositions of clause 4, Me$^1$ is a combination of both Ga and In.

7) Compositions of clause 4, Me$^2$ is a combination of both Si and Ge.

8) Compositions of clause 4, said matter is formed as crystals having a mean crystal size between 8 and 40 times its peak emission wavelength.

9) Compositions of matter in accordance with:

$$La_{3-x}[Ln]_xGa_5 Si O_{14}$$

where x is $0 \leq x \leq .3$, and [Ln] is a lanthanide.

10) Compositions of clause 9, Ln is cerium.

11) The combination of clause 2, said photophosphor is prepared in accordance with:

$$La_{3-x}[Me^1]_5[Me^2]_1O_{14}:[At]_x$$

where:

Me$^1$ is at least one group III metal from the group comprising: Ga or In;
Me$^2$ is at least one group IV metal from the group comprising: Si or Ge;
At$_x$ is the total of at least one lanthanide from the group: Ce, Sc, Y, Gd, Yb, Lu, Sm, Eu, Tb, Er, Dy, Pr, Ho and Tm, where:

$$A_{t_x} = \sum_{i=1}^{N} A_{i x_i} \quad ; \text{where } 1 \leq N \leq 14$$

and x is less than 3.

12) The combination of clause 1, where 'proximately positioned' is further defined as a colloid formed as a phosphor-polymer suspension being coated over said semiconductor light emitter.

13) The combination of clause 12, said polymer is further defined as a polyethylsiloxane or polyepoxide having mass about between 2000 to 20000 carbon units.

14) The combination of clause 12, phosphor-polymer by mass is between .1 and .75.

15) The combination of clause 14, layer thickness is about between 20-100 microns.

16) A semiconductor diode partially covered by Langasite doped with a lanthanide.

17) The device of clause 16, said semiconductor diode is an InGaN structure.

18) The device of clause 16 said lanthanide is cerium.

19) The device of clause 16, said 'partially covered' is further defined as Langasite crystals arranged in a colloid.

20) The device of clause 19, said colloid is comprised of a polymer binder.

**Claims**

1. Compositions of matter in accordance with:

$$La_{3-x}[Me^1]_5[Me^2]_1O_{14}:[At]_x$$

where:

Me$^1$ is at least one group III Metal from the group comprising: Ga or In;
Me$^2$ is at least one group IV Metal from the group comprising: Si or Ge;
At$_x$ is the total of at least one lanthanide from the group: Ce, Sc, Y, Gd, Yb, Lu, Sm, Eu, Tb, Er, Dy, Pr, Ho and Tm, where:

$$A_{t_x} = \sum_{i=1}^{N} A_{i x_i} \quad ; \text{where } 1 \leq N \leq 14$$

and x is less than 3.

2. Compositions of claim 1, said material is formed as crystals having a crystalline structure **characterized by**:

$$P_{321} (D^2_3)$$

3. Compositions of claim 1, Me$^1$ is a combination of both Ga and In.

4. Compositions of claim 1, Me$^2$ is a combination of both Si and Ge.

5. Compositions of claim 1, said matter is formed as crystals having a mean crystal size between 8 and 40 times its peak emission wavelength.

6. Compositions of matter in accordance with:

$$La_{3-x}[Ln]_x Ga_5 Si O_{14}$$

where x is $0 \leq x \leq .3$, and [Ln] is a lanthanide.

7. Compositions of claim 6, Ln is cerium.

Fig. 1

Fig. 2

Europäisches
Patentamt

European
Patent Office

Office européen
des brevets

**EUROPEAN SEARCH REPORT**

Application Number

EP 11 17 0909

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | JP 2004 075890 A (KONICA MINOLTA HOLDINGS INC) 11 March 2004 (2004-03-11) * paragraph [0018]; compounds GF-8 * ----- | 1-7 | INV. C09K11/80 H01L33/00 |
| X | JP 2004 074049 A (KONICA MINOLTA HOLDINGS INC) 11 March 2004 (2004-03-11) * paragraph [0009]; compounds GF-8 * ----- | 1-7 | |
| X | NIKOLAJSEN T ET AL: "PHOTOREFRACTIVE TWO-STEP RECORDING IN A PIEZOELECTRIC LA3GA5SIO14 CRYSTAL DOPED WITH PRASEODYMIUM", OPTICS LETTERS, OSA, OPTICAL SOCIETY OF AMERICA, WASHINGTON, DC, US, vol. 23, no. 15, 1 August 1998 (1998-08-01), pages 1164-1166, XP000783063, ISSN: 0146-9592 * the whole document * ----- | 1-4,6,7 | |
| X | WANG Z ET AL: "Growth and optical properties of Eu<3+>-doped La3Ga5SiO14 single crystal", JOURNAL OF CRYSTAL GROWTH, ELSEVIER, AMSTERDAM, NL, vol. 255, no. 3-4, 1 August 2003 (2003-08-01), pages 348-352, XP004434572, ISSN: 0022-0248, DOI: 10.1016/S0022-0248(03)01269-7 * the whole document * ----- -/-- | 1-4,6,7 | TECHNICAL FIELDS SEARCHED (IPC) H01L C09K |

The present search report has been drawn up for all claims

| Place of search | Date of completion of the search | Examiner |
|---|---|---|
| The Hague | 30 September 2011 | Delaporte, P |

CATEGORY OF CITED DOCUMENTS

X : particularly relevant if taken alone
Y : particularly relevant if combined with another
    document of the same category
A : technological background
O : non-written disclosure
P : intermediate document

T : theory or principle underlying the invention
E : earlier patent document, but published on, or
    after the filing date
D : document cited in the application
L : document cited for other reasons

.................................................................................................

& : member of the same patent family, corresponding
    document

EPO FORM 1503 03.82 (P04C01)

Europäisches
Patentamt

European
Patent Office

Office européen
des brevets

## EUROPEAN SEARCH REPORT

Application Number

EP 11 17 0909

### DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | KAMINSKII A A ET AL: "SPECTROSCOPY OF DISORDERED LA3GA5SIO14 CRYSTALS ACTIVATED WITH PR+3,HO+3,AND ER+3 IONS1)", OPTICS AND SPECTROSCOPY, M A I K NAUKA - INTERPERIODICA, RU, vol. 68, no. 4, 1 April 1990 (1990-04-01), pages 520-525, XP000260994, ISSN: 0030-400X * the whole document * | 1-4,6,7 | |
| X | WANG Z ET AL: "Crystal growth and optical properties of Dy: La3Ga5SiO14 single crystals", JOURNAL OF CRYSTAL GROWTH, ELSEVIER, AMSTERDAM, NL, vol. 263, no. 1-4, 1 March 2004 (2004-03-01), pages 246-250, XP004908582, ISSN: 0022-0248, DOI: 10.1016/J.JCRYSGRO.2003.11.087 * the whole document * | 1-4,6,7 | |
| X | KIM Y S ET AL: "Tm-doped Langasite (La3Ga5SiO14) crystals grown by the Czochralski method for optical applications", MATERIALS LETTERS, NORTH HOLLAND PUBLISHING COMPANY. AMSTERDAM, NL, vol. 57, no. 1, 1 November 2002 (2002-11-01), pages 28-31, XP004392406, ISSN: 0167-577X * the whole document * | 1-4,6,7 | TECHNICAL FIELDS SEARCHED (IPC) |

-/--

The present search report has been drawn up for all claims

| Place of search | Date of completion of the search | Examiner |
|---|---|---|
| The Hague | 30 September 2011 | Delaporte, P |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

Europäisches
Patentamt

European
Patent Office

Office européen
des brevets

## EUROPEAN SEARCH REPORT

Application Number

EP 11 17 0909

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | WANG Z ET AL: "Crystal growth and spectroscopic properties of Er:La3Ga5SiO14 single crystals", JOURNAL OF CRYSTAL GROWTH, ELSEVIER, AMSTERDAM, NL, vol. 257, no. 1-2, 1 September 2003 (2003-09-01), pages 141-145, XP004450894, ISSN: 0022-0248, DOI: 10.1016/S0022-0248(03)01411-8 * the whole document * | 1-4,6,7 | |
| X | DATABASE CA [Online] CHEMICAL ABSTRACTS SERVICE, COLUMBUS, OHIO, US; 2004, DOMOROSHCHINA, E. N. ET AL: "Link between growth regimes, structure, and optical properties of the La3Ga5SiO14 langisite crystals", XP002416095, retrieved from STN Database accession no. 2004:907435 * the whole document * & PERSPEKTIVNYE MATERIALY , (4), 17-30 CODEN: PRMTFY; ISSN: 1028-978X, 2004, | 1-4,6,7 | |
| A | US 6 069 440 A (SHIMIZU YOSHINORI [JP] ET AL) 30 May 2000 (2000-05-30) * column 23, line 42 - column 24, line 63 * | 1-7 | TECHNICAL FIELDS SEARCHED (IPC) |

The present search report has been drawn up for all claims

| Place of search | Date of completion of the search | Examiner |
|---|---|---|
| The Hague | 30 September 2011 | Delaporte, P |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

## ANNEX TO THE EUROPEAN SEARCH REPORT
## ON EUROPEAN PATENT APPLICATION NO.

EP 11 17 0909

This annex lists the patent family members relating to the patent documents cited in the above-mentioned European search report.
The members are as contained in the European Patent Office EDP file on
The European Patent Office is in no way liable for these particulars which are merely given for the purpose of information.

30-09-2011

| Patent document cited in search report | | Publication date | Patent family member(s) | Publication date |
|---|---|---|---|---|
| JP 2004075890 | A | 11-03-2004 | NONE | |
| JP 2004074049 | A | 11-03-2004 | NONE | |
| US 6069440 | A | 30-05-2000 | NONE | |

EPO FORM P0459

For more details about this annex : see Official Journal of the European Patent Office, No. 12/82

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 6303048 B
- US 6525447 B, Kumatoriya
- US 20020015452 A
- US 6069440 A